# EUROPÄISCHE PATENTSCHRIFT

(11) **EP 1 345 269 B1**
(45) Veröffentlichungstag und Bekanntmachung des Hinweises auf die Patenterteilung: **04.06.2008**
(21) Anmeldenummer: 02027807.3
(22) Anmeldetag: 12.12.2002
(51) Int. Cl.: H01L 23/473

(54) **Kühlvorrichtung für elektronische/elektrische Komponenten**
Cooling device for electronic/electrical components
Dispositif de refroidissement pour composants électroniques/électriques

(30) Priorität: 23.02.2002 DE 10207873
(43) Veröffentlichungstag der Anmeldung: 17.09.2003
(73) Patentinhaber: Modine Manufacturing Company, Racine, Wisconsin 53403-2552 (US)
(72) Erfinder: Brost, Viktor, Dipl.-Ing., 72631 Aichtal (DE)
(74) Vertreter: Wolter, Klaus-Dietrich

(56) Entgegenhaltungen:
- EP-A- 0 618 618
- US-A- 3 649 738
- US-A- 5 510 958

## Beschreibung

Die Erfindung betrifft eine Kühlvorrichtung für elektronische / elektrische Komponenten im Kraftfahrzeug, umfassend, eine Platte, an der die Komponenten Wärme leitend befestigt sind, einen Strömungskanal im Wärme leitenden Kontakt mit der Platte und mit einem Kühlflüssigkeitseingang und einem Kühlflüssigkeitsausgang.

Solche Kühlvorrichtungen sind bekannt, beispielsweise aus EP 1 096 647 A2. Es muss nicht extra betont werden, dass elektronische Komponenten, die im Betrieb Wärme erzeugen, die abgeführt werden muss, auch im Kraftfahrzeug mehr und mehr Platz greifen. So wird beispielsweise Heute noch daran gearbeitet, den Starter für den Antriebsmotor gleichzeitig als Generator zu betreiben, um elektrische Verbraucher zu bedienen und die Batterien des Kraftfahrzeuges aufzuladen. Dadurch wird eine gesamte bisher erforderliche Komponente (Lichtmaschine oder Starter) des Kraftfahrzeuges eingespart. In der Peripherie solcher bereits lange laufender Entwicklungen ist die vorliegende Erfindung angesiedelt, denn besonders die dazu erforderliche Leistungselektronik benötigt eine effiziente Kühlung. Aber auch andere elektronische / elektrische Komponenten zur Steuerung und Regelung beispielsweise von Elektromotoren im Kraftfahrzeug haben Kühlungsbedarf. Darauf bezieht sich das eingangs erwähnte Dokument. Die Kühlflüssigkeit scheint dort ein Öl zu sein.

Es bietet sich an, zur Kühlung dieser Komponenten Kühlflüssigkeit zu verwenden, die sowieso zur Kühlung anderer Aggregate, beispielsweise zur Kühlung des Antriebsmotors, vorhanden sein muss und die mittels Kühlmittelpumpe im Kühlkreislauf zirkuliert.

Die Kühlung mittels der Kühlflüssigkeit, bspw, des Antriebsmotors eines Kfz, unterscheidet sich von der für die beschriebenen Zwecke oftmals eingesetzten Siedebadkühlung - einer Art Verdampfungskühlung - vor allem dadurch, dass bei der Siedebadkühlung die gesamte Leiterplatte mit den elektronischen Komponenten in einem Behälter untergebracht und darin von nicht elektrisch leitender Flüssigkeit umspült ist. Dabei hat man den Vorteil, dass sämtliche elektronischen Komponenten, die unterschiedlich große Verlust - Wärmemengen erzeugen, einer Kühlung unterzogen werden, so dass Überhitzungen einzelner Punkte vermieden werden können. Eine solche Vorrichtung ist Gegenstand der noch nicht veröffentlichten DE 101 58 387.7.

Eine andere Lösung, bei der ebenfalls eine nicht elektrisch leitende Flüssigkeit verwendet wird, ist aus dem EP 618 618A1 bekannt, und sie weist die vorstehend beschriebenen Vorteile auf. Dort soll die Vereisung der Vorrichtung vermieden werden, weshalb eine Isolation vorgesehen wurde.

Die bereits oben kurz angerissene Kühlung mittels Kühlflüssigkeit bringt ein Problem mit sich, das darin besteht, dass die Energie benötigende Kühlmittelpumpe nur dann eingeschaltet wird, wenn ein Kühlungsbedarf des Antriebsmotors (oder anderer Hauptbedarfsträger!) besteht. (dynamischer Betriebsfall) Untergeordnete Baugruppen mit Kühlbedarf müssen sich daran orientieren bzw. gegenüber dem Bedarf des Hauptbedarfsträgers zurücktreten. Also gibt es sogar recht häufig Betriebsfälle, in denen die elektronischen Komponenten gekühlt werden müssen, aber die Kühlmittelpumpe nicht in Betrieb ist, so dass die Kühlung der elektronischen Komponenten auf Probleme trifft. (statischer Betriebsfall) Auf diesen Betriebsfall kann mit der aus der DE 199 59 023 A1 bekannten Vorrichtung zur Kühlung elektronischer Bauelemente, nicht reagiert werden, denn das Gehäuse dieser Vorrichtung ist als Anbaugehäuse am Gehäuse der Kühlmittelpumpe angebracht, wobei das Anbaugehäuse - wenn überhaupt - nur dann durchströmt ist, wenn die Pumpe arbeitet, also im dynamischen Betriebsfall.

Demzufolge hat sich der Erfinder die Aufgabe gestellt, eine effiziente Kühlung elektronischer Komponenten im Kfz mit einer kostengünstigen Kühlvorrichtung zu erreichen, wobei die Kühlvorrichtung so gestaltet sein soll, dass sie ohne wesentliche Änderungen hauptsächlich für den dynamischen Betriebsfall geeignet ist.

Die Aufgabe wird durch die im Anspruch 1 genannten Merkmale gelöst.

Die Merkmale der Ansprüche 2 und 3 gewährleisten eine effiziente Kühlung in beiden Betriebsfällen, wobei zur Kühlung im statischen Betriebsfall der mit Kühlflüssigkeit gefüllte Behälter vorgesehen ist.

Die Merkmale des Anspruchs 4 führen dazu, dass die Kühlvorrichtung ohne wesentliche Änderungen nur für den dynamischen Betriebsfall wirksam ist. Bei dieser Kühlvorrichtung ist im Wesentlichen der Deckel des Behälters zum Abschluß desselben, der für beide Betriebsfälle vorgesehen ist, weggelassen worden. Es wird also ein baugleicher jedoch offener Behälter vorgesehen, in dem sich kein Kühlflüssigkeitsdepot befindet.

Die Kühlvorrichtung besteht aus einem Mantelteil mit einer Wand und aus einem tiefgezogenen Behälterteil mit einer Wand, wobei das Behälterteil in das Mantelteil einsetzbar ist, so dass zwischen der Wand des Behälterteils und der Wand des Mantelteils der Strömungskanal ausgebildet ist. Auch das Mantelteil ist ein tiefgezogenes Teil.

Wenn, angrenzend und in Wärme leitendem Kontakt mit dem Strömungskanal ein im wesentlichen geschlossener Behälter angeordnet ist, in dem sich ein Kühlflüssigkeitsdepot befindet, dann wird im dynamischen Betriebsfall die Kühlflüssigkeit im Behälter die von den elektronischen Komponenten abgegebene Wärme mit aufnehmen. Es besteht eine Wärme leitende Verbindung zwischen dem Strömungskanal und dem Behälter, denn beide sind lediglich durch eine dünne Wand aus Aluminiumblech voneinander getrennt. Auch zwischen dem Strömungskanal und der Leiterplatte ist vorzugsweise lediglich eine Wand vorgesehen, die dann gleichzeitig die Rückseite der Leiterplatte sein kann. In diesem Betriebsfall strömt die Kühlflüssigkeit durch den Strömungskanal, denn die Pumpe ist in Betrieb. Im statischen Betriebsfall (ohne Durchströmung des Strömungskanals) ist es die Aufgabe der Flüssigkeitsdepots im Behälter, die von den Komponenten abgegebene Wärme aufzunehmen und über die Wand des Behälters nach außen abzugeben. Im statischen Betriebsfall befindet sich im Strömungskanal in der Regel auch Kühlflüssigkeit, die jedoch nicht zirkuliert sondern ruht. Der erwähnte Behälter muss nicht besonders groß sein und damit viel Raum belegen, der in modernen Kraftfahrzeugen sehr knapp bemessen ist. Im Einzelfall wird die Größe des Behälters bzw. des Depots von der abzuführenden Wärmemenge abhängen und von anderen Randbedingungen. In einem bevorzugten Fall wurden mit einem Behälter, der ein Fassungsvermögen von lediglich 0,3 Liter hat gute Erfahrungen gemacht. Zwischen dem Strömungskanal und dem Behälter besteht eine Strömungsverbindung zur Volumenausdehnung / Entgasung der Kühlflüssigkeit. Im dynamischen Betriebsfall wird sich jedoch in der Regel keine oder lediglich eine vernachlässigbare Durchströmung des Behälters einstellen. Die Größe der Strömungsverbindung kann jedoch im Zusammenhang mit der erforderlichen Größe des Behälters gesehen werden.

Um den Anordnungen der Komponenten auf der Platte und ihren unterschiedlich hohen Verlustwärmemengen zu entsprechen, sind in der einen Wand des Strömungskanals Führungen zur Vergleichmäßigung und Verteilung der Strömung im Strömungskanal eingeprägt. Die Führungen können einfach mit Hilfe eines Werkzeugs in die Wand des Strömungskanals eingeprägt werden. Ihre Anordnung und Form kann beliebig vorgesehen sein. Je nachdem wo sich die besonders zu kühlenden heißen Punkte an der Leiterplatte befinden, kann der Kühlmittelstrom durch die Anordnung der Führungen entsprechend gelenkt werden. Die Führungen sind Sicken, die in ihrer Höhe mit der Höhe des Strömungskanals übereinstimmen, so dass der Sickenfirst an der anderen Wand des Strömungskanals verlötet werden kann. Durch die Führungen wird die Strömung auf dem Weg vom Eintrit in den Strömungskanal bis zum Austritt aus demselben in eine Vielzahl einzelner Kanäle aufgeteilt. Dadurch wird erreicht werden, dass ein bspw. im Zentrum der Platte (oder anderswo) angeordneter Chip, der relativ wenig Verlustwärme erzeugt, auch nur ein dem entsprechender geringer Anteil der gesamten Strömungsmenge zugeführt wird.

Alternativ zu den Führungen ist in dem Strömungskanal ein Turbulenzorgan eingelegt, wobei vorzugsweise eine Lamelle mit versetzten Schnitten aus dem Bereich "Ölkühler" vorgesehen wird, die im wärmeleitenden Kontakt zur Wand des Strömungskanals steht.

In dem Behälter ist ein Inneneinsatz angeordnet, der im wärmeleitenden Kontakt mit der Wand des Behälters steht. Dadurch wird die Abführung der Wärme über die Wand des Behälters verbessert.

Der Strömungskanal weist vorzugsweise einen etwas größeren horizontalen Querschnitt auf als der Behälter im Bereich seines Bodens. Der Strömungskanal ist jedoch im vertikalen Querschnitt sehr flach im Vergleich zum vertikalen Querschnitt des Behälters ausgebildet. Der flache Strömungskanal führt zu hoher Strömungsgeschwindigkeit verbunden mit einer hohen Wärmeaustauschrate im Strömungskanal.

Eine kompakte Bauweise der Kühlvorrichtung ergibt sich, wenn der Kühlflüssigkeitseingang und der Kühflüssigkeitsausgang in / aus den Strömungskanal durch den Behälter hindurchgehen. Je nach Anschlußbedingungen kann der Eingang und der Ausgang jedoch auch auf der gegenüber liegenden Seite des Strömungskanals angeordnet sein, wobei sie dann folglich nicht durch den Behälter hindurchgehen. Ferner könnte der Eingang (oder Ausgang) durch den Behälter hindurchgehen und der Ausgang (oder Eingang) entsprechend anders angeordnet sein.

Die Kühlflüssigkeit ist vorzugsweise die Kühlflüssigkeit des Antriebsmotors, jedoch könnte auch beispielsweise Kühlöl in Frage kommen, das mittels Pumpe in einem Kreislauf zirkuliert, denn auch dort treten die vorne beschriebenen statischen und dynamischen Betriebsfälle auf.

Sämtliche Teile der Kühlvorrichtung sind aus Aluminiumblech gefertigt, das zweckentsprechend mit Lot plattiert ist, wobei die Teile in einer einzigen Lötoperation verbindbar sind. Weitere Merkmale sind Gegenstand der Patentansprüche.

Die Erfindung wird im Folgenden anhand von Ausführungsbeispielen beschrieben. Aus der Beschreibung gehen noch andere Merkmale und deren vorteilhaften Wirkungen hervor.

Die Figuren zeigen:
**Fig. 1** ein Querschnitt durch die Kühlvorrichtung, gemäß H - H, in Fig. 2;
**Fig. 2** eine Draufsicht auf die Kühlvorrichtung;
**Fig. 3** und **Fig. 4** zeigen Draufsicht und Schnitt durch die Vorrichtung für den dynamischen Betriebsfall;
**Fig. 5** und **6** zeigen die Ausführung nach den **Fig. 1** und **2** im Einzelnen;
**Fig. 7** eine Seitenansicht auf die Kühlvorrichtung;
**Fig. 8** Schnitt A-A aus **Fig. 7****;**
**Fig. 9 - 12** zeigen Seitenansichten und Draufsichten auf das Behälterteil mit verschiedenen Gestaltungen des Strömungskanals;
**Fig. 13** und **14** zeigt Seitenansicht und Draufsicht von **Fig. 3** und **4****;**
**Fig. 15** und **16** zeigen zwei unterschiedliche Anschlussarten der Stutzen;

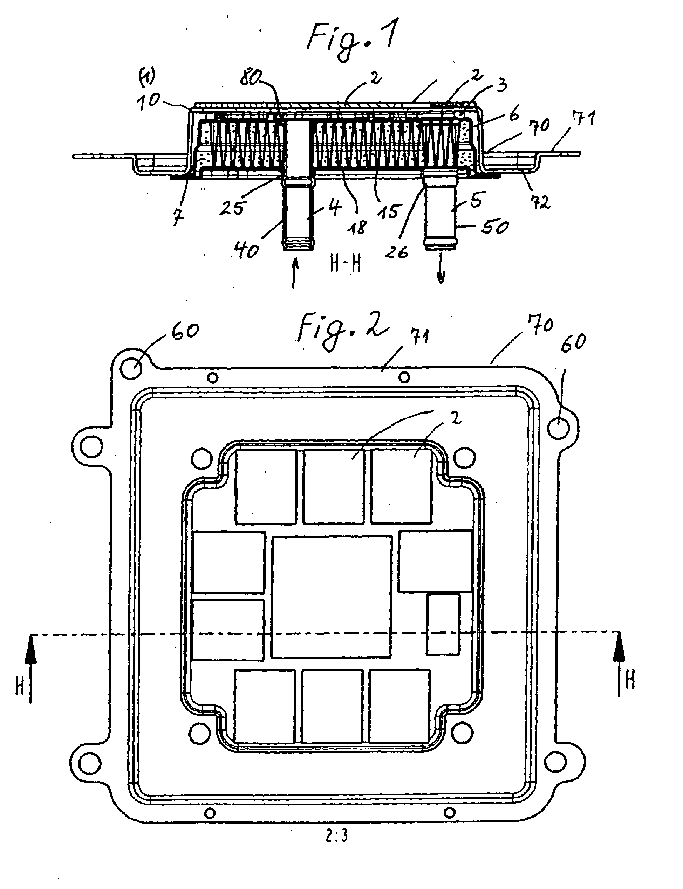

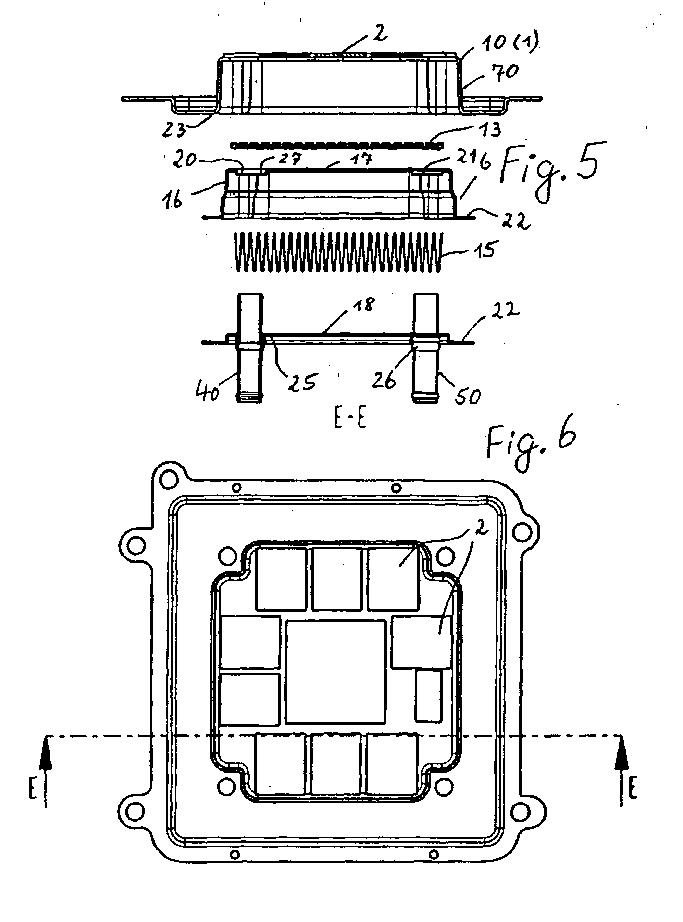

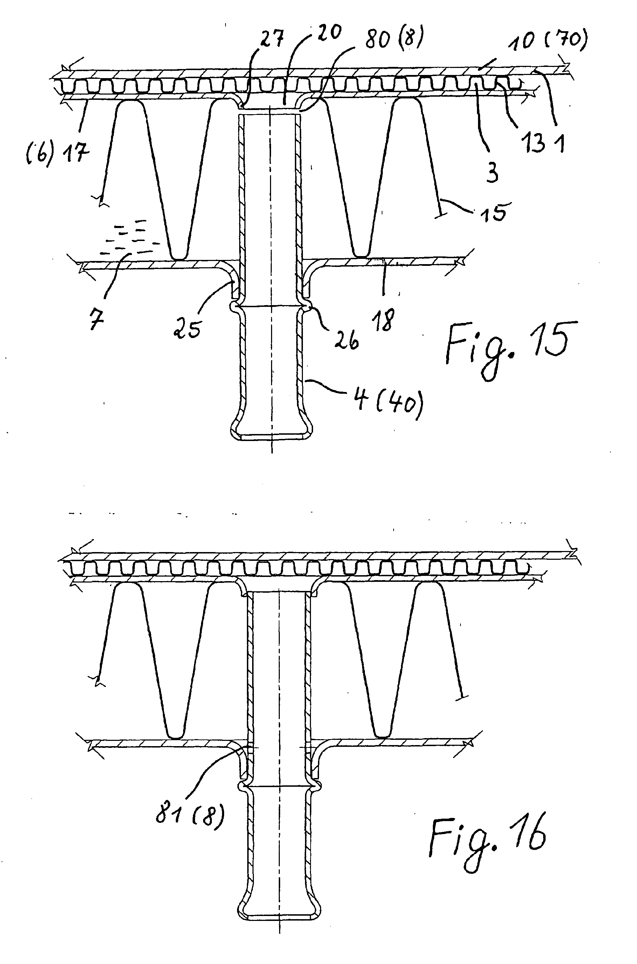

Zunächst sollen die zusammengehörigen **Figuren 1** und **2** sowie **5** und **6** beschrieben werden. Die Kühlvorrichtung wird aus lotbeschichtetem Aluminiumblech hergestellt. Die Einzelteile dieser für den statischen und den dynamischen Betriebsfall geeigneten Kühlvorrichtung sind aus **Fig. 5** besonders deutlich erkennbar. Es wurde bei der Ausbildung der Einzelteile strikt darauf geachtet, dass die Herstellung der Kühlvorrichtung mit hoher Lötqualität und zu geringen Kosten möglich ist. Demnach besteht die Kühlvorrichtung aus dem Behälter **6**, der wiederum gewöhnlich eine Wand **16** aufweist, zu der ein Boden **17** gehört. Komplettiert wird der Behälter **6** durch einen Deckel **18**. In dem Behälter **6** befindet sich ein Kühlflüssigkeitsdepot **7**. Das Behälterteil **6** ist ein mittels Tiefziehen hergestelltes Behälterteil **6**, das topfartig ausgebildet ist, wobei die Wand **16** aus einem umlaufenden Abschnitt und dem Boden **17** besteht. Unter "topfartig" soll im vorliegenden Zusammenhang nicht nur eine runde Form verstanden werden, sondern der erwähnte Begriff soll alle denkbaren Formen einschließen, die einen Boden und eine umlaufende Wand aufweisen. Aus den Figuren ist zu sehen, dass die Form des Behälterteils **6** und des Mantelteils **70** (siehe unten) etwa viereckig ist. An die Wand **16** des Behälterteils **6** schließt sich ein Randflansch **22** an, der später zur löttechnischen Verbindung am Deckel **18** vorgesehen ist. Im Boden **17** befinden sich zwei Öffnungen **20**, **21**, um die herum ein Rand **27** angeformt ist, auf den jedoch in einem nicht gezeigten Ausführungsbeispiel verzichtet wurde. Als Kühlflüssigkeitseingang **4** und - ausgang **5** sind runde Stutzen **40** bzw. **50** vorgesehen. Der Deckel **18** ist ein im wesentlichen ebenes Teil, in dem ebenfalls entsprechende Öffnungen mit einem Lötrand **25** (Fig. 5) für die Stutzen **40**, **50** vorhanden sind. An diesem Lötrand **25** erfolgt später die löttechnische Verbindung mit den Stutzen **40**, **50**. Die Stutzen **40**, **50** selbst sind an sich bekannter Ausführung mit einer Ringsicke **26**, die am Lötrand **25** anliegt. Zwischen den Enden der Stutzen **40**, **50** und dem Rand **27** hat der Erfinder einen Ringspalt **80** (Fig. 1) vorgesehen. Dieser Ringspalt **80** bildet die strömungstechnische Verbindung **8** zwischen der Kühlflüssigkeit im Strömungskanal **3** und im Behälter **6**. Insbesondere im statischen Betriebsfall hat die sich erwärmende Kühlflüssigkeit **7** im Behälter **6** das Bestreben sich auszudehnen. Diesem Bestreben wurde durch das Vorsehen des Ringspalts **80** entsprochen. Der Erfinder betont, dass weitere konstruktive Varianten vorhanden sind, die mit dem Ringspalt **80** wirkungsmäßig gleichwertig sind. Eine andere Gestaltung ist in Fig. 16 gezeigt, die später beschrieben wird. Der Ringspalt **80** an der beschriebenen Stelle und mit der beschriebenen Ausbildung ist vorteilhaft, weil damit gleichzeitig auf die Lötverbindung zwischen Stutzen **40, 50** und Rand **27** verzichtet werden kann. Im Behälter **6** befindet sich ein Inneneinsatz **15,** der später mit der Wand **16**, Boden **17** und Deckel **18** verbunden wird. Der Inneneinsatz **15** hat Wellenform und weist selbstverständlich in diesem Ausführungsbeispiel wenigstens zwei nicht gezeigte Löcher auf, um die Stutzen **40**, **50** hindurchführen zu können. Die eine Wand **10** des Strömungskanals **3** ist Teil eines ebenfalls tiefgezogenen Mantelteils **70**, an dem rund herum ein Befestigungsflansch **71** mit Öffnungen **60** ausgebildet wurde, um die gesamte Kühlvorrichtung im Kraftfahrzeug an geeigneter Stelle positionieren, befestigen und anschließen zu können. Die beschriebenen Einzelteile werden, wie in der Fig. 5 gezeigt, vormontiert. Da das Behälterteil **6** etwas kleiner als das Mantelteil **70** ist, bildet sich zwischen den Wänden **10** und **16** ein Strömungskanal **3** aus. Das Behälterteil **6** und das Mantelteil **70** sind so dimensioniert, dass nach dem Einsetzen des Behälterteils **6** in das Mantelteil **70** der verbleibende Strömungskanal **3** relativ flach ist. Das beschriebene Ausführungsbeispiel besitzt Stutzen **40** und **50**, die im Bild vertikal durch den Behälter **6** hindurchgehen, um im Strömungskanal **3** zu münden. Somit ist die Anschlußlage in dieser Ausführungsform festgelegt. Die Zuführung und Abführung der Kühlflüssigkeit erfolgt von unten. Nach Abschluß der Vormontage, wie gezeigt und beschrieben wurde, werden die Teile der Kühlvorrichtung in einem einzigen Lötvorgang miteinander fest und dicht verbunden. Es stellt sich eine Lötverbindung zwischen den Rändern **22** des Behälters **6** und dem Rand **23** des Mantelteils **70** ein aber auch zwischen den angrenzenden Wänden **10**, **17** und der Lamelle **13**, im Strömungskanal **3** und ferner zwischen den Wänden **10**,**17**, **18** des Behälters **6** und seinem Inneneinsatz **15**. Nach erfolgtem Lötvorgang werden die Komponenten **2** an der Wand **10** (Platte **1**) des Strömungskanals **3** von außen so befestigt, dass ein guter Wärmeübergang von den Komponenten **2** zur Wand **10** vorhanden ist. Die Wand **10** ist somit gleichzeitig die Platte **1**, bzw. deren Rückseite. Die Komponenten **2** besitzen in der Regel einen Boden aus Keramik oder dergleichen, so dass sie elektrisch von der Wand **10** isoliert sind. In nicht gezeigten Ausführungen ist zusätzlich eine Platte **1** mit den Komponenten **2** an der Wand **10** mit guter Wärmeleitung befestigt worden. In den Fig. 2 und 6 ist die Anordnung der Komponenten **2** außen auf der Platte **1** (Wand **10**) identisch. Die Komponenten 2 werden mit einem wärmeleitenden Kleber auf der Platte **1** befestigt, sie könnten jedoch auch andersartig befestigt sein, wobei stets auf einen guten Wärmeübergang zu achten ist.

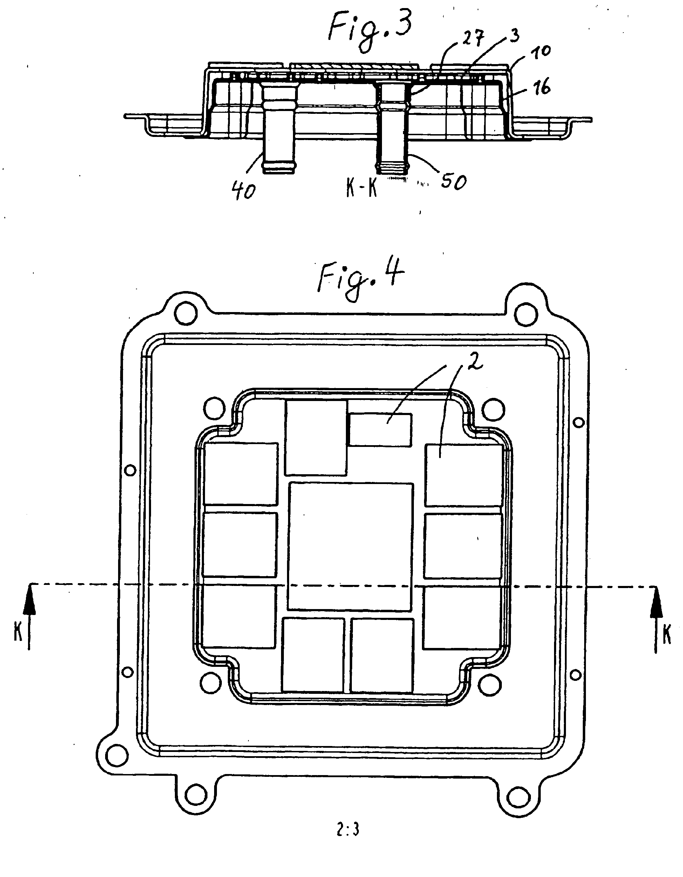

Die Fig. 3 und 4 zeigen den weiteren Vorteil der Erfindung, der darin besteht, dass mit relativ geringen Änderungen des Designs bzw. unter Verwendung gleicher Teile der Kühlvorrichtung, für einen Anwendungsfall, der keine Kühlung der Komponenten **2** im statischen Betriebsfall erfordert, möglich ist. Wie die Figuren zeigen, wurde der Deckel **18** einfach weggelassen und die Verbindung der Stutzen **40**, **50** wurde zu den Öffnungen **20**, **21** mit Lötrand **27** in der Wand **16** (Boden **17**) des (vormaligen) Behälters **6** verlegt. Dazu sind an den Einzelteilen der Kühlvorrichtung selbst keine Veränderungen erforderlich. Es sollten lediglich Stutzen **40**, **50** verwendet werden, die mit dem Lötrand **27** an den Öffnungen **20**, **21**, angelötet werden können. Der Lötrand **27** ist einfach der abgebogene Rand der Öffnungen **20**, **21**. Wie die Abbildungen zeigen, kann der Lötrand **27** in gleicher Weise ausgebildet sein, ob er tatsächlich ein Lötrand **27** ist oder lediglich ein abgebogener Rand **27** an den Öffnungen **20**, **21**, der für das Vorsehen des oben erwähnten Ringspalts **80** genutzt wird.

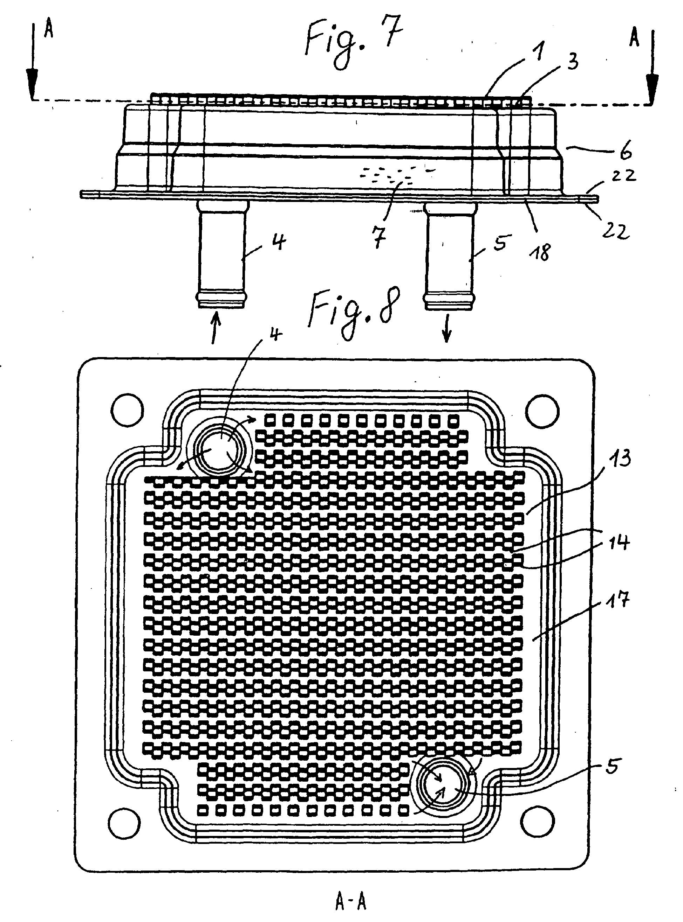

In den **Fig. 7** und **8** ist die verwendete Öllamelle **13**, die sich im Strömungskanal **3** befindet, im Detail gezeigt. Die sogenannten Schnitte **14** in der Lamelle **13**, bzw. in deren Wellen, sind zueinander versetzt angeordnet. Wenn solche wie in **Fig. 8** gezeigten Lamellen **13** in (im Bild) horizontaler Richtung - also parallel zu den Wellen - durchströmt werden, ist der Druckverlust minimiert, aber die Wärmeaustauschrate nicht besonders hoch. Würden die Lamellen **13** in (im Bild) vertikaler Richtung - also senkrecht zu den Wellen - durchströmt werden, stellt sich ein nachteilig hoher Druckverlust ein jedoch auch eine sehr gute Wärmeaustauschrate. Somit kann durch spezielle Anordnung solcher Lamellen **13** ein Optimum hinsichtlich geringem Druckverlust bei geforderter Wärmeaustauschrate erzielt werden. In der **Fig. 8** ist die Lamelle **13** etwa so angeordnet, dass eine gedachte Verbindungslinie zwischen Eingang **4** und Ausgang **5** etwa einen Winkel von 45° zur Horizontalen bzw. zu den Wellen der Lamelle **13** einnimmt.

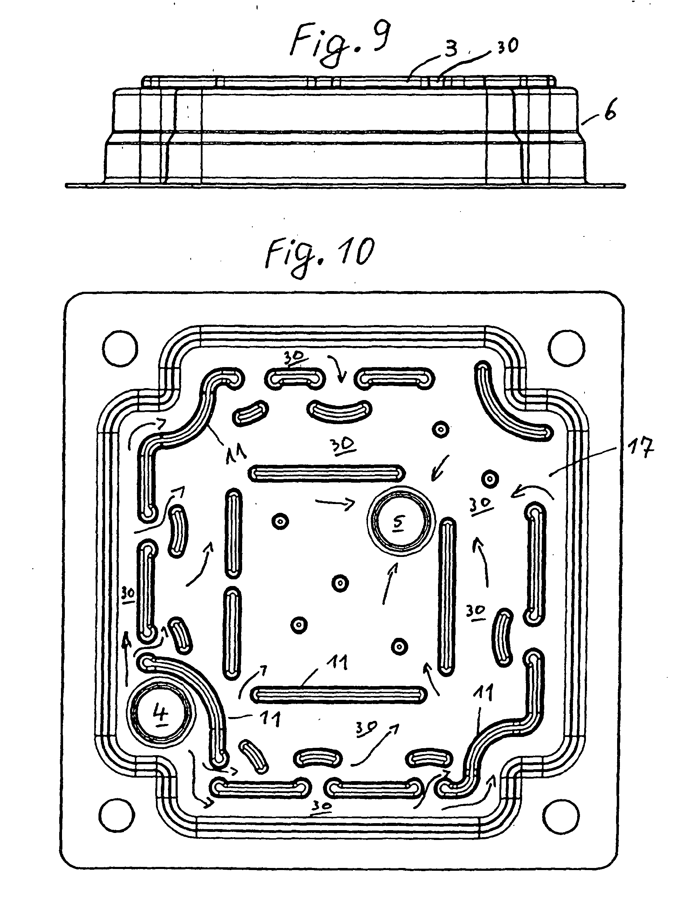

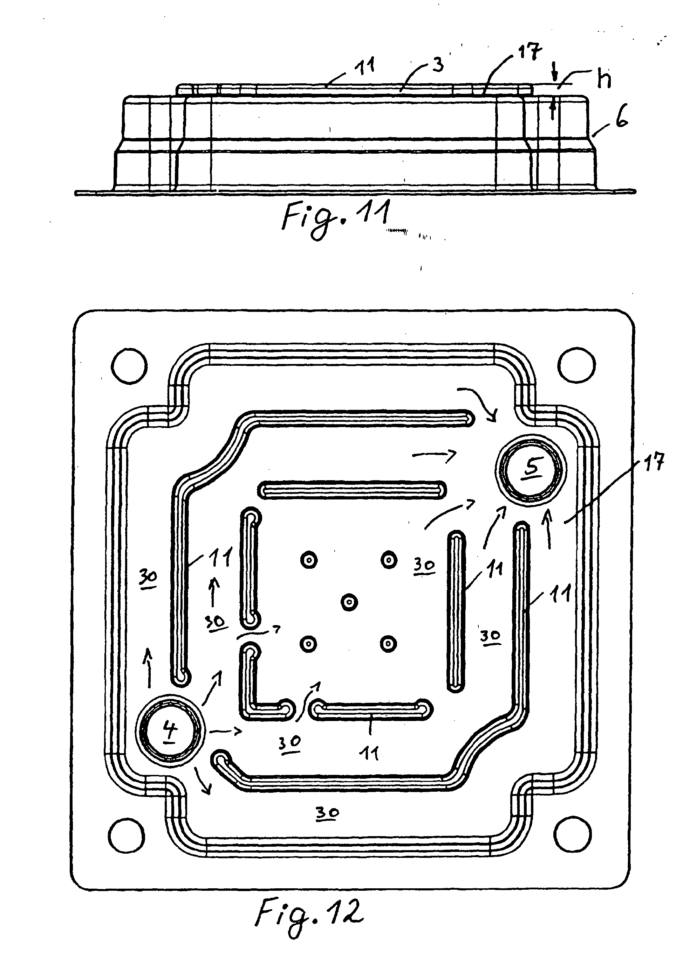

In den Fig. **9- 12**, die nur Ansichten des Behälterteils **6** zeigen, wurde komplett auf Lamellen **13** im Strömungskanal **3** verzichtet. Anstelle der Lamelle **13** wurden in die Wand **16** des Behälterteils **6** - genauer - in dem den Boden **17** bildenden Teil der Wand **16** Führungen **11** eingeprägt, die praktisch Sicken sind. Die Sicken **11** sind mit ihrem First an der anderen Wand **10** (Fig. 1) des Strömungskanals **3** verlötet, d. h. sie besitzen die Höhe **h**, die gleich der Höhe des Strömungskanals **3** ist. Zwischen den Sicken **11** ergeben sich somit im Strömungskanal **3** schmälere, breitere, kleinere, größere, kürzere, längere, gerade und/oder gebogene - eben verschieden gestaltete Kanäle **30**, die durch die Anordnung und Ausbildung der Sicken **11** die Kühlflüssigkeit so durch den Strömungskanal **3** lenken, wie es entsprechend der Position der Komponenten **2** und ihrer anfallenden Verlust - Wärmemengen erforderlich ist, um dieselben ausreichend zu kühlen. Die **Fig. 9** und **10** unterscheiden sich von den **Fig. 11** und **12** dadurch, dass der Eingang **4** und der Ausgang **5** andere Positionen aufweisen und die Führungen **11** hinsichtlich Anzahl, Position und Anordnung teilweise unterschiedlich sind. Damit wird der unterschiedlichen Anordnung und Wärmeabgabe der Komponenten **2** entsprochen. In den Figuren wurden nur einige der Kanäle 30 mit Strömungspfeilen und Bezugszeichen markiert.

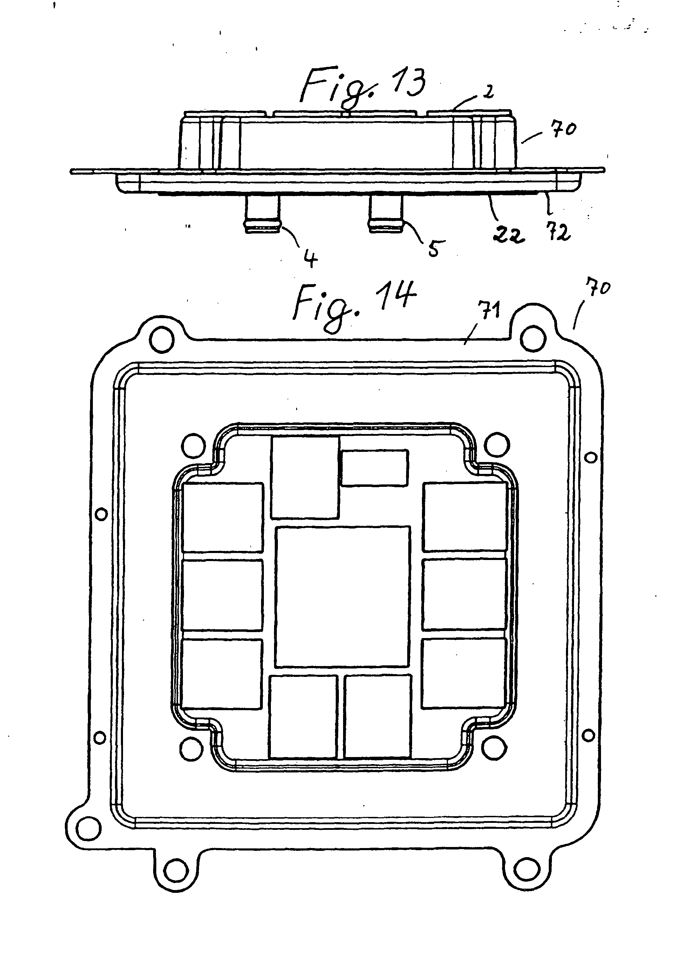

In der **Fig. 13** ist zu erkennen, dass das Mantelteil **70** zu seinem Befestigungsflansch **71** hin auch mit einer Versteifungssicke **72** ausgebildet sein kann. Im Unterschied dazu ist eine solche Versteifungssicke **72** beispielsweise in **Fig.7** nicht vorgesehen worden.

In den Fig. 15 und 16 sind zwei unterschiedliche Gestaltungen der Strömungsverbindung **8** zwischen dem Behälter **6** und dem Strömungskanal **3** im Detail dargestellt worden. Die **Fig. 15** kann als vergrößerte Darstellung des mit **80** (Ringspalt) bezeichneten Details in Fig. 1 angesehen werden. Der Ringspalt **80** ist nur wenige Millimeter breit und hat neben der Bereitstellung der Strömungsverbindung **8** zwischen dem Behälter **6** und dem Strömungskanal **3** noch den Vorteil, dass beim Einströmen/Ausströmen der Kühlflüssigkeit kaum ein spürbarer Druckverlust verursacht wird. Ein anderer wesentlicher Vorteil wird durch die in **Fig. 16** gezeigte Gestaltung erzielt. Dort sind die Stutzen **40 / 50** nahe am Deckel **18** des Behälters **6** mit Bohrungen **81** oder Schlitzen versehen worden, die die Strömungsverbindung **8** ermöglichen und gleichzeitig dafür sorgen können, dass der Behälter **6** entleert werden kann, was im Entsorgungsfall vorteilhaft ist.

## Patentansprüche

1. Kühlvorrichtung für elektronische/elektrische Komponenten im Kraftfahrzeug, umfassend: eine Platte (1), an der die Komponenten (2) Wärme leitend befestigt sind, einen Strömungskanal (3) mit einem Kühlflüssigkeitseingang (4) und einem Kühlflüssigkeitsausgang (5) und im Wärme leitenden Kontakt mit der Platte (1),
**dadurch gekennzeichnet, dass**
angrenzend an den Strömungskanal (3) und in Wärme leitendem Kontakt damit ein Behälterteil (6) mit einem Mantelteil (70) vorgesehen ist, wobei das Behälterteil (6) in das Mantelteil (70) einsetzbar ist, um dazwischen den Strömungskanal (3) auszubilden.

2. Kühlvorrichtung nach Anspruch 1, **dadurch gekennzeichnet, dass** das Behälterteil (6) Teil eines etwa baugleichen Behälters (6) ist, in dem sich ein Kühlflüssigkeitsdepot (7) befindet.

3. Kühlvorrichtung nach Anspruch 2, **dadurch gekennzeichnet, dass** zwischen dem Strömungskanal (3) und dem Behälter (6) eine Strömungsverbindung (8) zur Volumenausdehnung / Entgasung der Kühlflüssigkeit besteht.

4. Kühlvorrichtung gemäß einem der Ansprüche 1 -3,
**dadurch gekennzeichnet, dass** die Kühlvorrichtung aus Aluminiumblech gefertigt ist wobei das Mantelteil (70) und das Behälterteil (6) tiefgezogene Teile sind, mit einer Wand (10) und mit einer Wand (16), wobei der Strömungskanal (3) zwischen der Wand (16) und der Wand (10) ausgebildet ist.

5. Kühlvorrichtung nach einem der Ansprüche 1 - 4, **dadurch gekennzeichnet, dass** die Wand (10) des Mantelteils (6) aus einem Boden besteht, der die Rückseite der Platte (1) ist und aus einem um die Platte (1) laufenden Rand und dass die Wand (16) des Behälterteils (6) aus einem Boden (17) und einem um den Boden (17) laufenden Rand besteht, wobei der Strömungskanal (3) zumindest überwiegend zwischen der Rückseite der Platte (1) und dem Boden (17) des Behälterteils (6) angeordnet ist.

6. Kühlvorrichtung nach einem der Ansprüche 1 bis 5, **dadurch gekennzeichnet, dass** die Leiterplatte (1) die eine Wand (10) des Strömungskanals (3) ist, dass die andere Wand des Strömungskanals (3) die Wand (16) des Behälters (6) ist und dass in der Wand (16) Führungen (11) zur Vergleichmäßigung und Verteilung der Strömung im Strömungskanal (3) eingeprägt sind.

7. Kühlvorrichtung nach Anspruch 6, **dadurch gekennzeichnet, dass** die Führungen (11) Sicken sind, die mit ihrem First an der einen Wand (10) des Strömungskanals (3) verlötet sind, so dass die Strömung im Strömungskanal (3) in viele Kanäle (30) aufgeteilt ist.

8. Kühlvorrichtung nach den Ansprüchen 1 bis 5 , **dadurch gekennzeichnet, dass** in dem Strömungskanal (3) ein Turbulenzorgan (13) eingelegt ist, vorzugsweise eine Lamelle mit versetzten Schnitten (14) aus dem Bereich "Ölkühler", die im wärmeleitenden Kontakt zu den Wänden (10, 16) des Strömungskanals (3) steht.

9. Kühlvorrichtung nach einem der vorstehenden Ansprüche, **dadurch gekennzeichnet, dass** in dem Behälter (6) ein Inneneinsatz (15) angeordnet ist, der im Wärme leitenden Kontakt mit der Wand (16) des Behälters (6) bzw. des Strömungskanals (3) steht.

10. Kühlvorrichtung nach einem der vorstehenden Ansprüche, **dadurch gekennzeichnet, dass** der Strömungskanal (3) einen geringfügig größeren horizontalen Querschnitt aufweist als das Behälterteil (6) im Bereich seines Bodens, wobei der vertikale Querschnitt des Strömungskanals (3) im Vergleich zu demselben des Behälters (6) wesentlich flacher ist.

11. Kühlvorrichtung nach einem der vorstehenden Ansprüche, **dadurch gekennzeichnet, dass** der Kühlflüssigkeitseingang (4) und der Kühflüssigkeitsausgang (5) in / aus den Strömungskanal (3) durch das Behälterteil (6) oder durch den Behälter (6) hindurchgehen.

12. Kühlvorrichtung nach einem der vorstehenden Ansprüche, **dadurch gekennzeichnet, dass** sämtliche Teile der Kühlvorrichtung zweckentsprechend mit Lot plattiert sind, wobei die Teile in einer einzigen Lötoperation verbindbar sind.

13. Kühlvorrichtung nach einem der vorstehenden Ansprüche, **dadurch gekennzeichnet, dass** die Komponenten (2) mittels eines Wärme leitenden Klebers auf der Vorderseite der Leiterplatte (1) (Wand 10) befestigt sind.

14. Kühlvorrichtung nach einem der vorstehenden Ansprüche, **dadurch gekennzeichnet, dass** am Kühlflüssigkeitseingang (4) und/oder am Kühlflüssigkeitsausgang (5) eine Bohrung (81) oder dergleichen als Strömungsverbindung (8) und zur Entleerung des Behälters (6) angeordnet ist.

15. Kühlvorrichtung nach einem der vorstehenden Ansprüche, **dadurch gekennzeichnet, dass** die Strömungsverbindung (8) zwischen dem einen Ende des Kühlflüssigkeitseingangs (4) oder - ausgangs (5) und einer zugeordneten Öffnung (20, 21) in der Wand (16) des Behälterteils (6) bzw. der Wand des Strömungskanals (3) in Form eines Ringspalts (80) angeordnet ist.

## Claims

1. Cooling device for electronic/electrical components in a motor vehicle, comprising: a plate (1) to which the components (2) are attached in a thermally conductive fashion, a flow duct (3) which has a coolant inlet (4) and a coolant outlet (5) and is in thermally conductive contact with the plate (1), **characterized in that** a container part (6) with an outer casing part (70) is provided adjacent to the flow duct (3) and in thermally conductive contact with it, wherein the container part (6) can be inserted into the outer casing part (70) in order to form the flow duct (3) between them.

2. Cooling device according to Claim 1, **characterized in that** the container part (6) is part of an approximately structurally identical container (6) in which a coolant reservoir (7) is located.

3. Cooling device according to Claim 2, **characterized in that** between the flow duct (3) and the container (6) there is flow connection (8) for volume expansion/degassing of the coolant.

4. Cooling device according to one of Claims 1 to 3, **characterized in that** the cooling device is fabricated from sheet aluminium, wherein the outer casing part (70) and the container part (6) are deep-drawn parts, with a wall (10) and with a wall (16), wherein the flow duct (3) is formed between the wall (16) and the wall (10) .

5. Cooling device according to one of Claims 1 to 4, **characterized in that** the wall (10) of the outer casing part (6) is composed of a floor which is the rearside of the plate (1), and of an edge which runs around the plate (1), and **in that** the wall (16) of the container part (6) is composed of a floor (17) and an edge which runs around the floor (17), wherein the flow duct (3) is arranged at least mainly between the rearside of the plate (3) and the floor (17) of the container part (6).

6. Cooling device according to one of Claims 1 to 5, **characterized in that** the printed circuit board (1) is one (10) of the walls of the flow duct (3), **in that** the other wall of the flow duct (3) is the wall (16) of the container (6), and **in that** guides (11) for homogenizing and distributing the flow in the flow duct (3) are stamped into the wall (16).

7. Cooling device according to Claim 6, **characterized in that** the guides (11) are beads which are soldered by their ridge to one (10) of the walls of the flow duct (3) so that the flow in the flow duct (3) is divided into a large number of channels (30).

8. Cooling device according to Claims 1 to 5, **characterized in that** a turbulent element (13), preferably a lamellar with offset indents (14) from the field of "oil coolers" which is in thermally conductive contact with the walls (10, 16) of the flow duct (3) is inserted into the flow duct (3).

9. Cooling device according to one of the preceding claims, **characterized in that** an internal insert (15) which is in thermally conductive contact with the wall (16) of the container (6) or of the flow duct (3) is arranged in the container (6).

10. Cooling device according to one of the preceding claims, **characterized in that** the flow duct (3) has a slightly larger horizontal cross section than the container part (6) in the vicinity of its floor, wherein the vertical cross section of the flow duct (3) is substantially flatter than that of the container (6) .

11. Cooling device according to one of the preceding claims, **characterized in that** the coolant inlet (4) and the coolant outlet (5) pass in/out of the flow duct (3) through the container part (6) or through the container (6).

12. Cooling device according to one of the preceding claims, **characterized in that** all the parts of the cooling device are expediently plated with solder, wherein the parts can be connected in a single soldering operation.

13. Cooling device according to one of the preceding claims, **characterized in that** the components (2) are attached to the front side of the printed circuit board (1) (wall 10) by means of a thermally conductive adhesive.

14. Cooling device according to one of the preceding claims, **characterized in that** a bore (81) or the like is arranged as a flow connection (8) and for the purpose of emptying the container (6) at the coolant inlet (4) and/or at the coolant outlet (5).

15. Cooling device according to one of the preceding claims, **characterized in that** the flow connection (8) is arranged between one of the ends of the coolant inlet (4) or coolant outlet (5) and an assigned opening (20, 21) in the wall (16) of the container part (6) and/or the wall of the flow duct (3) in the form of an annular gap (80).

## Revendications

1. Dispositif de refroidissement pour composants électroniques/éleetriques dans un véhicule automobile, comprenant: une plaquette (1) sur laquelle les composants (2) sont fixés d'une manière conduisant la chaleur, un canal d'écoulement (3) avec une entrée de liquide de refroidissement (4) et une sortie de liquide de refroidissement (5) et en contact conducteur de la chaleur avec la plaquette (1), **caractérisé en ce qu'**il est prévu, à proximité du canal d'écoulement (3) et en contact conducteur de la chaleur avec celui-ci, une partie de boîtier (6) avec une partie d'enveloppe (70), dans lequel la partie de boîtier. (6) peut être introduite dans la partie d'enveloppe (70), pour former entre elles le canal d'écoulement (3).

2. Dispositif de refroidissement selon la revendication 1, **caractérisé en ce que** la partie de boîtier (6) fait partie d'un boîtier (6) de structure sensiblement identique, dans lequel se trouve un dépôt de liquide de refroidissement (7).

3. Dispositif de refroidissement selon la revendication 2, **caractérisé en ce qu'**il existe, entre le canal d'écoulement (3) et le boîtier (6), une communication d'écoulement (8) pour la dilatation de volume/le dégazage du liquide de refroidissement.

4. Dispositif de refroidissement selon l'une quelconque des revendications 1 à 3, **caractérisé en ce que** le dispositif de refroidissement est fabriqué en tôle d'aluminium, dans lequel la partie d'enveloppe (70) et la partie de boîtier (6) sont des pièces embouties, avec une paroi (10) et avec une paroi (16), dans lequel le canal d'écoulement (3) est formé entre la paroi (16) et la paroi (10).

5. Dispositif de refroidissement selon l'une quelconque des revendications 1 à 4, **caractérisé en ce que** la paroi (10) de la partie d'enveloppe (70) se compose d'un fond, qui est la face arrière de la plaquette (1) et d'un bord s'étendant autour de la plaquette (1) et **en ce que** la paroi (16) de la partie de boîtier (6) se compose d'un fond (17) et d'un bord s'étendant autour du fond (17), dans lequel le canal d'écoulement (3) est disposé au moins principalement entre la face arrière de la plaquette (1) et le fond (17) de la partie de boîtier (6).

6. Dispositif de refroidissement selon l'une quelconque des revendications 1 à 5, **caractérisé en ce que** la plaquette de circuits imprimés (1) est la première paroi (10) du canal d'écoulement (3), **en ce que** l'autre paroi du canal d'écoulement (3) est la paroi (16) du boîtier (6) et **en ce que** des guides (11) sont défoncés dans la paroi (16) pour uniformiser et distribuer l'écoulement dans le canal d'écoulement (3).

7. Dispositif de refroidissement selon la revendication 6, **caractérisé en ce que** les guides (11) sont des moulures, qui sont brasées par leur crête à la première paroi (10) du canal d'écoulement (3), de telle manière que l'écoulement dans le canal d'écoulement (3) soit réparti dans de nombreux canaux (30).

8. Dispositif de refroidissement selon l'une quelconque des revendications 1 à 5, **caractérisé en ce qu'**un organe de turbulence (13) est installé dans le canal d'écoulement (3), de préférence une lamelle avec des découpes décalées (14) hors de la zone "refroidisseur d'huile", qui est en contact conducteur de chaleur avec les parois (10, 16) du canal d'écoulement (3).

9. Dispositif de refroidissement selon l'une quelconque des revendications précédentes, **caractérisé en ce qu'**un insert intérieur (15) est disposé dans le boîtier (6), et est en contact conducteur de chaleur avec la paroi (16) du boîtier (6) ou du canal d'écoulement (3).

10. Dispositif de refroidissement selon l'une quelconque des revendications précédentes, **caractérisé en ce que** le canal d'écoulement (3) présente une section transversale horizontale légèrement plus grande que la partie de boîtier (6) dans la région de son fond, dans lequel la section transversale verticale du canal d'écoulement (3) est sensiblement plus plate, comparée à celle du boîtier (6).

11. Dispositif de refroidissement selon l'une quelconque des revendications précédentes, **caractérisé en ce que** l'entrée de liquide de refroidissement (4) et la sortie de liquide de refroidissement (5) dans le/hors du canal d'écoulement (3) passent à travers la partie de boîtier (6) ou à travers le boîtier (6).

12. Dispositif de refroidissement selon l'une quelconque des revendications précédentes, **caractérisé en ce que** toutes les pièces du dispositif de refroidissement sont revêtues de brasure conformément à l'objectif, dans lequel les pièces peuvent être assemblées en une seule opération de brasage.

13. Dispositif de refroidissement selon l'une quelconque des revendications précédentes, **caractérisé en ce que** les composants (2) sont fixés sur la face avant de la plaquette de circuits imprimés (1) (paroi 10) au moyen d'une colle conductrice de la chaleur.

14. Dispositif de refroidissement selon l'une quelconque des revendications précédentes, **caractérisé en ce qu'**un perçage (81) ou analogue est disposé à l'entrée de liquide de refroidissement (4) et/ou à la sortie de liquide de refroidissement (5), pour former la communication d'écoulement (8) et pour la vidange du boîtier (6).

15. Dispositif de refroidissement selon l'une quelconque des revendications précédentes, **caractérisé en ce que** la communication d'écoulement (8) entre la première extrémité de l'entrée (4) ou de la sortie (5) de liquide de refroidissement et une ouverture associée (20, 21) est disposée dans la paroi (16) de la partie de boîtier (6) ou dans la paroi du canal d'écoulement (3) sous la forme d'une fente annulaire (80).
